# EUROPEAN PATENT SPECIFICATION

(11) **EP 1 469 348 B1**
(45) Date of publication and mention of the grant of the patent: **18.01.2012**
(21) Application number: 04076129.8
(22) Date of filing: 08.04.2004
(51) Int. Cl.: G03F 7/20

(54) **Projection system and method of use thereof**
Projektionssystem und Verfahren zu dessen Verwendung
Sysème de projection et méthode d'utilisation

(30) Priority: 14.04.2003 EP 03076107
(43) Date of publication of application: 20.10.2004
(73) Proprietor: ASML Netherlands B.V., 5504 DR Veldhoven (NL)
(72) Inventor: Leenders, Martinus Hendrikus Antonius, 3039 ER Rotterdam (NL); Cox, Henrikus Herman Marie, 5646 JH Eindhoven (NL); Levasier, Leon Martin, 5321 NH Hedel (NL)
(74) Representative: Maas, Abraham Johannes

(56) References cited:
- EP-A- 0 742 492
- EP-A- 0 866 374
- EP-A- 1 137 054
- EP-A1- 1 385 058
- US-A- 5 105 075
- US-A1- 2002 044 269
- US-A1- 2003 042 920
- PATENT ABSTRACTS OF JAPAN vol. 2002, no. 04, 4 August 2002 (2002-08-04) & JP 2001 351855 A (ASM LITHOGRAPHY BV), 21 December 2001 (2001-12-21)

## Description

### FIELD OF THE INVENTION

The present invention relates to a projection system, comprising at least one projection device arranged to receive a projection beam coming from a first object and to project that projection beam to a second object, the projection system further comprising at least one sensor for measuring a spatial orientation of the at least one projection device.

The present further relates to a method of using such a projection system.

### PRIOR ART

The term "patterning devices" as here employed should be broadly interpreted as referring to devices that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning devices include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case extreme ultraviolet light is used, only reflective masks can be used, for reasons well known to a person skilled in the art. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation devices. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic devices. In both of the situations described hereabove, the patterning devices can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required; and
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning devices as hereabove set forth.

Lithographic projection apparatus can be used, for example, in the manufacture of integrated circuits (ICs). In such a case, the patterning devices may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC (Integrated Circuit). Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

The projection system as described above usually comprises one or more, for instance six, projection devices, such as lenses and/or mirrors. The projection devices transmit the projection beam through the projection system and direct it to the target portion. In case the projection beam is EUV-radiation, mirrors should be used in stead of lenses, in order to project the projection beam, since lenses are not translucent to EUV-radiation.

When an extreme ultraviolet projection beam is used for projecting relatively small patterns, the demands for the projection system concerning the accuracy are rather high. For instance, a mirror, that is positioned with a tilting error of 1 nrad, can result in a projection error of approximately 4 nm on the wafer, assuming an optical light path of 1m.

A projection system for projecting an extreme ultraviolet projection beam comprises, for instance, 6 mirrors. Usually, one of the mirrors has a fixed spatial orientation, while the other five are mounted with an active mount. The actuator in the active mount can be a Lorentz motor, a piezo, a pneumatic actuator or of other type. These mounts can preferably adjust the orientation of the mirrors in 6 degrees of freedom (6-DoF-mounts) using 6 degrees Lorentz engines per mirror. The projection system further comprises position sensors for measuring the spatial orientation of the projection devices, e.g. by measuring the position of the projection device relative to the projection system.

The projection system is mounted to the fixed world, for instance, a metro frame, using a medium soft mount with a suspension frequency between 10 and 100 Hz, typically a 30 Hz mounting device is used. This is done to stabilize the projection beam and isolate it from vibrations and disturbances coming from the metro frame environment and disturbances from adjacent systems. As a result of this mounting, unwanted high frequency disturbances above the 30 Hz are almost completely filtered out. However, disturbances having a frequency of approximately 30 Hz, are not stopped by the mounting device and are even amplified.

EP 0.866.374 discloses an exposure apparatus for projecting an image pattern on a mask onto a photosensitive substrate, wherein the apparatus comprises a measuring device for measuring the position of either one of the mask and the substrate, a vibration sensor for measuring vibration of a body including a projecting optical system, and a position controller for controlling the position of either one of the mask and the substrate based on a measurement value of the vibration sensor and a measurement value of the measuring device.

US 2002/0044269 discloses an exposure apparatus which has a strain measurement unit for measuring strain of a structure to which a position measurement unit is fixed for measuring the position of a substrate stage, wherein the substrate is aligned by the drive control of the stage in consideration of the measured strain.

US 2003/0042920 discloses a projection optical system in which the displacement of a correction lens form a target position is monitored during scanning and exposure, and wherein in case of the positional displacement exceeds an allowable range an error is displayed and the operation is stopped.

EP 1.137.054 discloses an exposure system in which the position of the mask and the substrate are controlled relative to an optical projection system.

US 5.105.075 discloses a projection exposure apparatus including a projection optical system for projecting an image of a pattern of a first object to a second object, and an adjusting system for adjusting projection magnification and distortion of the projected image of the pattern, the adjusting system being operable to displace the first object and a lens element of the projection optical system in a direction of an optical axis of the projection optical system. (→ page 5b)

### SLTMMARY OF THE INVENTION

It is an object of the present invention to provide a projection system that is less sensitive to vibrations and disturbances. This and other objects are achieved according to the invention in a projection system characterised in, that the projection system comprises at least one processing unit, that is arranged to communicate with the at least one sensor and the at least one processing unit is further arranged to communicate with a positioning device, arranged to adjust the position of at least one of the first and second object based on the measured spatial orientation of the at least one projection device. Such a projection system is arranged to compensate for errors in the positioning of the projecting devices. The spatial orientation is preferably measured relative to an optical reference frame, such as the projection system. The positions of the first and second object are preferably also measured with respect to this projection system. Unwanted disturbances, such as vibrations, can thus be compensated by applying signals from the projecting devices to the servo motors that control the position of the first and/or second object.

The processing unit is further arranged to communicate with a further positioning device, arranged to adjust the spatial orientation of the at least one projection device based on the measured spatial orientation of the at least one projection device. This ensures an even more accurate and complete system for compensating for measured errors.

The projection system is arranged to adjust the position of at least one of the first and second object, based on a residual error after adjusting the spatial orientation of the at least one projection device. Such an apparatus compensates errors even more effectively.

According to a further embodiment of the present invention, the processing unit is arranged to adjust the position of at least one of the first and second object based on the measured spatial orientation of the at least one projection device in a first frequency range and to adjust the spatial orientation of the at least one projection device based on the measured spatial orientation of the at least one projection device in a second frequency range. This is in particular very useful for cases wherein the actuators of the projection devices and the first and second object have different operational frequency ranges.

According to a further embodiment of the present invention, the at least one projection device comprises at least one of mirror and lenses. Such projection devices are commonly used. Especially in cases using extreme ultra violet radiation, mirrors are used for projecting the beam.

According to a further embodiment of the present invention, the at least one projection device is mounted on the further positioning device arranged to actuate the at least one projection device in at least one up to 6 degrees of freedom. This provides the projection devices with an optimal freedom of movement.

According to a further embodiment of the present invention, the projection beam is an extreme ultraviolet radiation beam. Extreme ultraviolet radiation is particularly used in cases very fine patterns need to be projected. In such cases, the demands for accurately projecting the image are likewise very high.

According to a further embodiment of the present invention, the at least one processing unit is further arranged to communicate with at least one further sensor to determine a position of at least one of the first and second object, preferably with respect to the projection system. This information is needed to position the first and second object even more accurately.

According to a further embodiment of the present invention, the at least one processing unit comprises an I/O-device, a micro-processor and a memory device. Such a processing unit could, e.g., be a computer, providing an easy and cost -effective way of processing the data and actuating the positioning devices.

The invention further relates to a method for use of a projection system, comprising at least one projection device arranged to receive a projection beam coming from a first object and to project that projection beam to a second object, the projection system further comprising at least one sensor for measuring a spatial orientation of the at least one projection device, the method comprising
- measuring the spatial orientation of the at least one projection device with the at least one sensor,
- determining an orientation error of the spatial orientation of the at least one projection device,
- adjusting the spatial orientation of the at least one projection device based on the orientation error;
- determining a residual error of the spatial orientation after adjusting the spatial orientation of the at least one projection device;
- computing a projection error in the image projected on the second object based on the residual error in the spatial orientation of the at least one projection device,
- adjusting a position of at least one of the first and second object in order to minimize said projection error.

According to a further embodiment the method comprises applying a transmission image sensor to improve the accuracy of the calibrated alignment of the first object to the second object in one up to 6 degrees of freedom, using the computed projection error of the image projected on the second object.

The use of such a transmission image sensor (TIS) is advantageously used in obtaining an accurate alignment between the first and second object.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

### BRIEF DESCRIPTION OF THE DRAWINGS

Embodiments of the invention will now be described, by way of example only, with reference to the accompanying schematic drawings in which corresponding reference symbols indicate corresponding parts, and in which:
- Figure 1 depicts a lithographic projection apparatus in which the projection system of the invention could be incorporated;
- Figure 2 depicts a projection system according to the prior art;
- Figure 3a and 3b depict a projection system according to different embodiments of the invention;
- Figure 4 depicts a processing unit that can be used in the projection system according to the invention.

### DESCRIPTION OF THE PREFERRED EMBODIMENTS

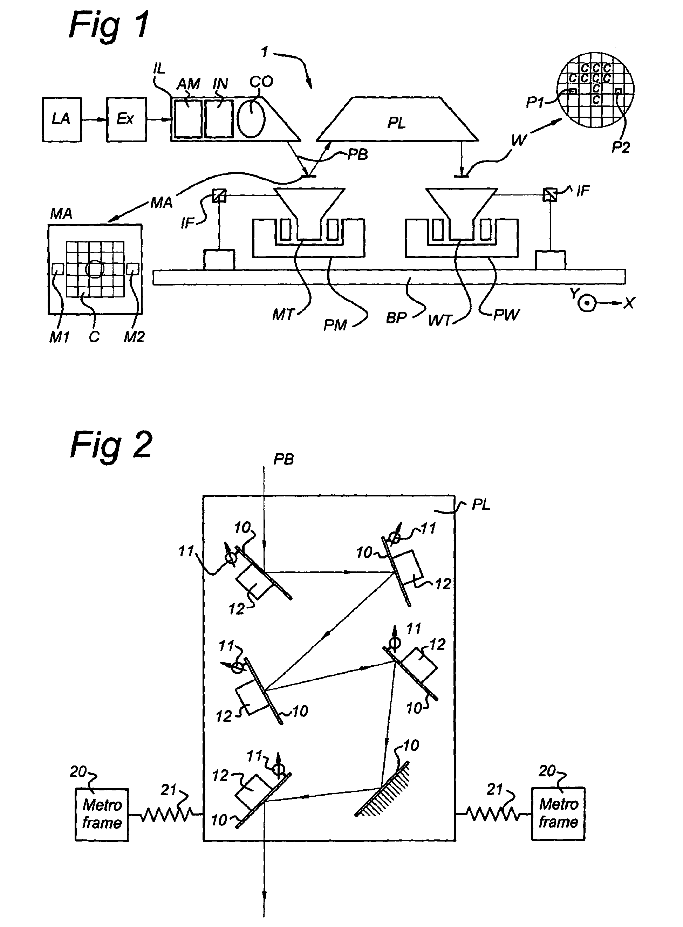

Figure 1 schematically depicts a lithographic projection apparatus 1 according to a particular embodiment of a lithographic projection apparatus. The apparatus comprises:
- a radiation system Ex, IL, for supplying a projection beam PB of radiation (e.g. EUV-radiation). In this particular case, the radiation system also comprises a radiation source LA;
- a first object table (mask table) MT provided with a mask holder for holding a mask MA (e.g. a reticle), and connected to first positioning devices PM for accurately positioning the mask with respect to item PL;
- a second object table (substrate table) WT provided with a substrate holder for holding a substrate W (e.g. a resist-coated silicon wafer), and connected to second positioning devices PW for accurately positioning the substrate with respect to item PL; and
- a projection system ("lens") PL (e.g. mirrors for EUV-radiation) or imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning devices, such as a programmable mirror array of a type as referred to above.

The source LA (e.g. EUV-source) produces a beam of radiation. This beam is fed into an illumination system (illuminator) IL, either directly or after having traversed conditioning devices, such as a beam expander Ex, for example. The illuminator IL may comprise adjusting devices AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning devices PW (and e.g. an interferometric position measuring devices IF), the substrate table WT can be moved accurately, e.g. so as to position different target portions C in the path of the beam PB. Similarly, the first positioning devices PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

Figure 2 depicts an example of a known projection system PL, as already discussed above. The projection system PL comprises one or more, typically six projection devices 10, here shown as mirrors. One of the projection devices 10 is fixedly mounted to the frame of the projection system PL, the other five projection devices 10 are mounted with the use of a 6-DoF-actuated mount 12, that can adjust the spatial orientation of the projection devices 10 in, preferably 6 degrees of freedom. The actuated mount can also be formed by a combination of passive DoF's and active DoF's. The projection system PL as a whole is mounted to the fixed world, for instance, a metro frame 20 by a medium soft mounting device 21, with a suspension frequency between 10 and 50 Hz, typically 30 Hz mounting device 21 connecting the projection system PL with the metro frame 20. The projection system PL further comprises sensors 11 to measure the relative position of the projection devices 10 with respect to the frame of the projection system PL. The orientation of the projection devices 10 is preferably measured relative to the projection system PL.

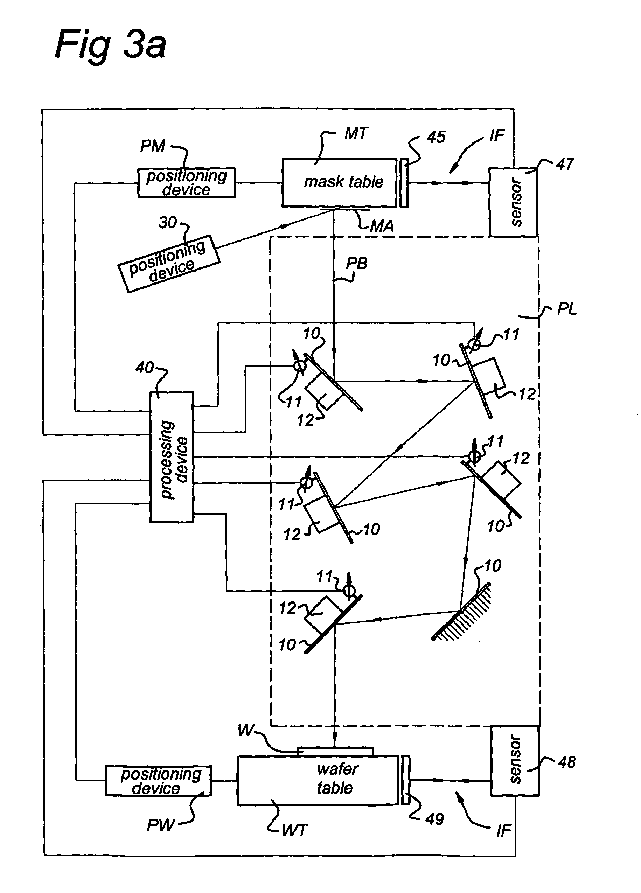

Fig. 3a shows a projection system PL according to the invention, in which the same reference numbers refer to similar items as in Fig. 2. Fig. 3a shows a mask MA on a mask table MT. A projection beam PB is produced by a projection device 30, that can be similar to the one discussed with reference to Fig. 1.

The projection system PL further comprises a processing unit 40 that is arranged to communicate with the sensors 11 and the 6-DOF-mount 12. The sensors 11 can measure the spatial orientation of the projection devices, e.g. with respect to the projection system PL and transmit that measured value to the processing unit 40.

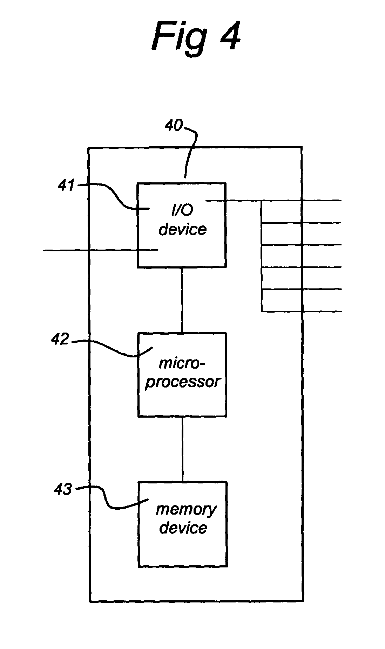

The processing unit 40 can be arranged as a computer with one or more processor devices in a way that will be clear to a person skilled in the art and of which an example is shown in Fig. 4. The processing unit 40 can comprise a micro-processor 42 that is arranged to communicate with a memory device 43 and an I/O-device 41. The I/O-device 41 is arranged to receive and transmit signals.

As is shown in Fig. 3a, the processing device 40 receives position input signals from sensors 11 of the optical elements and input signals 47 and 48 of the mask (MT) and wafer table (WT). The position sensors measure the position of optical elements with respect to the optical reference frame, i.e. the projection system PL, that becomes disturbed by vibrations on the metro frame 20 as result of scanning forces, floor vibrations or other disturbances.

The memory 43 compromises information about the desired ideal position (set point position) of each optical element. Any deviation of the desired position and the actual or sensor position (=position error) results in a correction signal (=control signal) to the actuators 12 of the optical elements. These correction signals form the output of the processing device 40 that controls the actuators 12 of the optical elements 10 in such away that the relative position error between optical elements 10 and projection system PL is kept as small as possible. This control can be obtained by one ore more position control loops that apply feedback and feedforward control outputs as result of a position error, velocity error, acceleration error and/or time integral of position error. The algorithms applied in the control loops are well known to those skilled in the art of servo control. The actuators 12 of the optical elements 10 are preferable of Lorentz type, but can also be electromagnetic, piezo, pneumatic ore another motor type.

If the position control loops of the optical elements 10 have a high position bandwidth the control can be powerful enough to minimize the relative error of each individual optical element 10 to the projection system PL. If optical elements 10 have the correct desired position and if all position errors are small enough, the combination of all optical elements 10 will result in a correct image of the mask pattern MA to the wafer W.

However if the disturbances are high and or if the position bandwidth is not high enough, the residual position error of the optical elements 10 may be too large for a good imaging. It is possible to improve the image quality of the projection of the mask MA on the wafer W, by feeding the residual errors of the optical elements 10 to one of the positioning devices PM (mask table) and/or PW (wafer table). This method is referred here as error feedthrough from the optical elements.

To do this, the contribution of each position error of each optical element 10 to the image on the wafer W must be known. This knowledge, the so-called sensitivity of the image error as function of position error can be obtained in advance by a calibration step. If the optical system has 5 active mirrors, controlled in 6 DOF, the result will be a sensitivity matrix with 30 independent inputs and 6 outputs, stored in the processing device 40. The inputs are individual position errors of the optical elements 10. The output are the corrections for the wafer table WT position and/or the mask table MT position. The sensitivity matrix then contains 5x6x6 = 180 gains that form the sensitivity of position error to image error on the wafer W. The 30 inputs and 6 outputs may or may not filter the input/output data. The weighted and filtered output then is added to the position sensor signal of the wafer table WT and/or mask table MT.

The position sensors 48 and 47 of the wafer table WT, respectively the mask table MT can be an interferometric measuring device IF as is shown in figure 3a, comprising a sensor 48, 47 and a mirror 49, 45. The interferometric measuring device IF measures the position of the wafer W, respectively mask MA with respect to the projection system PL.

Also optical encoders can be used as position sensor. The position device or actuator of the wafer W and mask MA are preferable of Lorentz type, but can also be electromagnetic, piezo, pneumatic or another motor type.

Adding the weighted position error of optical elements 10 to the position sensors of wafer table WT or mask table MT will further reduce the final image error of mask pattern to the wafer W. Typically the position error of the optical elements 10 will be dominated by the frequency of the suspension of optical frame to the metro frame 20. Typically position errors with 30 Hz frequency can be expected.

Those skilled in the art of position control can easily calculate that a 150 Hz servo bandwidth of the wafer table WT can give a reduction of approximately 1/0.3*(30/150)^2 =0.13 [-]. So a non compensated position error at wafer level of 10 nanometer becomes only 1.3 nanometer, when this error feedthrough is applied.

In an alternative configuration the weighted position error of optical elements 10 is not added to the position sensors 48 and/or 47 that form the control sensor input but is added as control output to the actuators for driving the wafer and mask (PW and PM respectively).

A further improvement is using the second derivative of the position error signal of the optical elements 10 as an acceleration feed forward signal to the position loop of wafer W and/or mask MA.

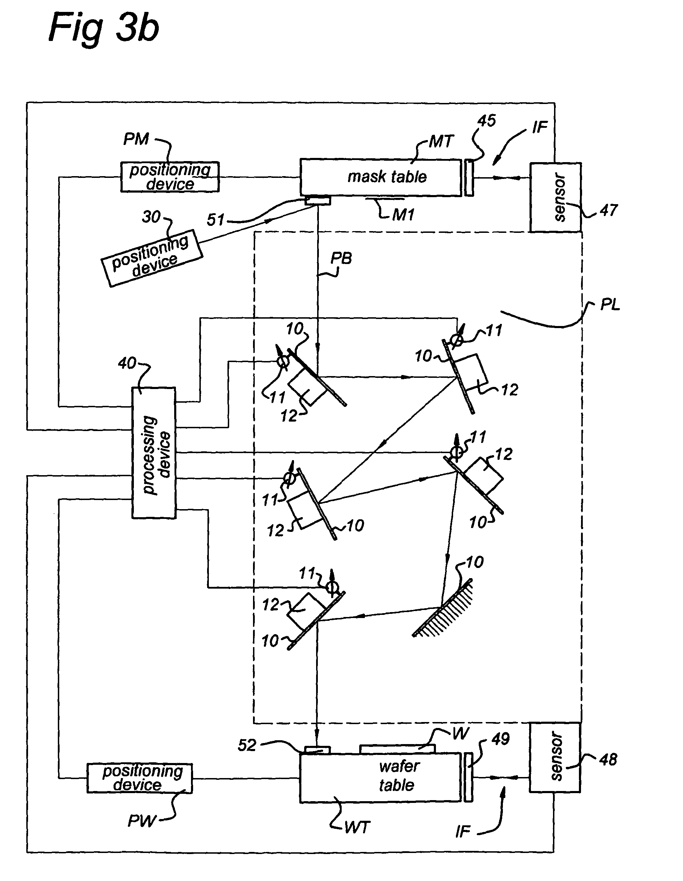

As is shown in Fig. 3b, the positioning of the mask table MT to the wafer table can also be monitored and calibrated by a TIS-device (TIS = Transmission Image Sensor). Such a TIS-device will readily be understood by a person skilled in the art

The TIS-device is formed by a test mark 51 on the mask table MT and an optical receiver 52 attached to the wafer table WT. The light from the projection device 30 projects the marker image via the optical elements 10 to the optical receiver 52. The projected image is a 3D parabolic-like light intensity distribution. The maximum of this intensity distribution can be used to find the optimal 6 DoF-alignment of the mask table MT relative to the wafer table WT. The accuracy of this mask table MT to the wafer table WT alignment via the TIS-device can also be much improved if the position error measured by the sensors 11 is weighted with the sensitivity matrix (described above) and if the result is added to the calibration position signal 48 and/or that forms the reference for the optimal mask table MT to wafer table WT position in co-ordinates to the sensors 47 and 48.

The measured errors of the projection devices 10, i.e. the deviation between the ideal and the actual spatial orientation of the projection devices 10, are used to adjust the position of the projection devices 10. Also the overall error computed by the processing unit 40, as described above, can be used to adjust the position of the projection devices 10, by controlling the actuators 12. The errors that remain after this adjustment (residual error) are compensated for by adjusting the position of the wafer table WT and/or the mask table MT, as already described above. This residual error can be measured, but can also be determined based on the original measured error and the knowledge about the compensation signal send to the actuators 12.

It is also possible to construct a time signal, representing the measured errors and convert this time signal into its frequency components. Certain frequency ranges can be compensated by adjusting the spatial orientation of the projection devices 10, other frequency ranges can be compensated by adjusting the position of the wafer table WT and/or the mask table MT.

In order to achieve optimal results, the measured signal, representing the measured errors, can be filtered, using known filter techniques. This can be done in order to control the positioning devices of the mask table PM, the wafer table PW and/or the projection devices 12 with a signal in a certain frequency range.

It will be understood that the invention as described here, is in general applied to projecting a projection beam PB coming from a first object to a second object. The objects can be all sort of objects, as for instance, the first object can be a mask MA for use in lithographic technology and the second object can be a wafer W for use in lithographic technology. The projection beam PB can be a patterned projection beam as used in lithographic technology.

Whilst specific embodiments of the invention have been described above, it will be appreciated that the invention may be practiced otherwise than as described. The description is not intended to limit the invention. The invention is limited by the scope of the appending claims only.

## Claims

1. Projection system, comprising at least one projection device (10) arranged to receive a projection beam (PB) coming from a first object (MA) and to project that projection beam to a second object (W),
the projection system (PL) further comprising at least one sensor (11) for measuring a spatial orientation of the at least one projection device (10),
wherein
the projection system (PL) comprises at least one processing unit (40) that is arranged to communicate with the at least one sensor (11), wherein
the at least one processing unit (40) is further arranged to communicate with a positioning device (PW, PM) arranged to adjust the position of at least one of the first (MA) and second object (W) based on the measured spatial orientation of the at least one projection device (10),
and wherein the processing unit (40) is further arranged to communicate with a further positioning device (12) arranged to adjust the spatial orientation of the at least one projection device (10) based on the measured spatial orientation of the at least one projection device (10),
**characterized in, that** the projection system is arranged to adjust the position of at least one of the first (MA) and second object (W), based on a residual error after adjusting the spatial orientation of the at least one projection device (10).

2. Projection system according to any of the preceding claims, **characterized in, that** the at least one projection device (10) comprises at least one of mirror and lenses.

3. Projection system according to any of the preceding claims, **characterized in, that** the at least one projection device (10) is mounted on the further positioning device (12) arranged to actuate the at least one projection device in at least one up to 6 degrees of freedom.

4. Projection system according to any of the preceding claims" **characterized in, that** the projection beam (PB) is an extreme ultraviolet radiation beam.

5. Projection system according to any of the preceding claims, **characterized in, that** the at least one processing unit (40) is further arranged to communicate with at least one further sensor (47, 48) to determine a position of at least one of the first (MA) and second object (W).

6. Projection system according to any of the preceding claims, **characterized in, that** the at least one processing unit (40) comprises an I/O-device (41), a microprocessor (42) and a memory device (43).

7. Method for use of a projection system (PL), comprising at least one projection device (10) arranged to receive a projection beam (PB) coming from a first object (MA) and to project that projection beam to a second object (W),
the projection system (PL) further comprising at least one sensor (11) for measuring a spatial orientation of the at least one projection device (10), the method comprising
- measuring the spatial orientation of the at least one projection device (10) with the at least one sensor (11),
- determining an orientation error in the spatial orientation of the at least one projection device (10),
- adjusting the spatial orientation of the at least one projection device based on the orientation error; - determining a residual error of the spatial orientation after adjusting the spatial orientation of the at least one projection device;
- computing a projection error of the image projected on the second object (W) based on the residual error in the spatial orientation of the at least one projection device (10),
- adjusting a position of at least one of the first (MA) and second object (W) in order to minimize said projection error.

## Patentansprüche

1. Ein Projektionssystem, das mindestens eine Projektionsvorrichtung (10) beinhaltet, die eingerichtet ist, um einen Projektionsstrahl (PB), der von einem ersten Objekt (MA) kommt, zu empfangen und um diesen Projektionsstrahl auf ein zweites Objekt (W) zu projizieren,
wobei das Projektionssystem (PL) ferner mindestens einen Sensor (11) zum Messen einer räumlichen Ausrichtung der mindestens einen Projektionsvorrichtung (10) beinhaltet,
wobei
das Projektionssystem (PL) mindestens eine Verarbeitungseinheit (40) beinhaltet, die eingerichtet ist, um mit dem mindestens einen Sensor (11) in Verbindung zu sein, wobei
die mindestens eine Verarbeitungseinheit (40) ferner eingerichtet ist, um mit einer Positionierungsvorrichtung (PW, PM) in Verbindung zu sein, die eingerichtet ist, um die Position von mindestens einem von dem ersten (MA) und dem zweiten Objekt (W) basierend auf der gemessenen räumlichen Ausrichtung der mindestens einen Projektionsvorrichtung (10) anzupassen,
und wobei die Verarbeitungseinheit (40) ferner eingerichtet ist, um mit einer weiteren Positionierungsvorrichtung (12) in Verbindung zu sein, die eingerichtet ist, um die räumliche Ausrichtung der mindestens einen Projektionsvorrichtung (10) basierend auf der gemessenen räumlichen Ausrichtung der mindestens einen Projektionsvorrichtung (10) anzupassen,
**dadurch gekennzeichnet, dass** das Projektionssystem eingerichtet ist, um die Position von mindestens einem von dem ersten (MA) und dem zweiten Objekt (W) basierend auf einem Restfehler nach dem Anpassen der räumlichen Ausrichtung der mindestens einen Projektionsvorrichtung (10) anzupassen.

2. Projektionssystem gemäß einem der vorhergehenden Ansprüche, **dadurch gekennzeichnet, dass** die mindestens eine Projektionsvorrichtung (10) mindesten eines von einem Spiegel und Linsen beinhaltet.

3. Projektionssystem gemäß einem der vorhergehenden Ansprüche, **dadurch gekennzeichnet, dass** die mindestens eine Projektionsvorrichtung (10) an der weiteren Positionierungsvorrichtung (12), die eingerichtet ist, um die mindestens eine Projektionsvorrichtung in mindestens einem bis hin zu 6 Freiheitsgraden zu betätigen, angebracht ist.

4. Projektionssystem gemäß einem der vorhergehenden Ansprüche, **dadurch gekennzeichnet, dass** der Projektionsstrahl (PB) ein Strahl aus extrem ultravioletter Strahlung ist.

5. Projektionssystem gemäß einem der vorhergehenden Ansprüche, **dadurch gekennzeichnet, dass** die mindestens eine Verarbeitungseinheit (40) ferner eingerichtet ist, um mit mindestens einem weiteren Sensor (47, 48) in Verbindung zu sein, um eine Position von mindestens einem von dem ersten (MA) und dem zweiten Objekt (W) zu bestimmen.

6. Projektionssystem gemäß einem der vorhergehenden Ansprüche, **dadurch gekennzeichnet, dass** die mindestens eine Verarbeitungseinheit (40) eine E/A-Vorrichtung (41), einen Mikroprozessor (42) und eine Speichervorrichtung (43) beinhaltet.

7. Ein Verfahren zur Verwendung eines Projektionssystems (PL), das mindestens eine Projektionsvorrichtung (10) beinhaltet, die eingerichtet ist, um einen Projektionsstrahl (PB), der von einem ersten Objekt (MA) kommt, zu empfangen und um diesen Projektionsstrahl auf ein zweites Objekt (W) zu projizieren, wobei das Projektionssystem (PL) ferner mindestens einen Sensor (11) zum Messen einer räumlichen Ausrichtung der mindestens einen Projektionsvorrichtung (10) beinhaltet, wobei das Verfahren Folgendes beinhaltet
- Messen der räumlichen Ausrichtung der mindestens einen Projektionsvorrichtung (10) mit dem mindestens einen Sensor (11),
- Bestimmen eines Ausrichtungsfehlers bei der räumlichen Ausrichtung der mindestens einen Projektionsvorrichtung (10),
- Anpassen der räumlichen Ausrichtung der mindestens einen Projektionsvorrichtung basierend auf dem Ausrichtungsfehler;
- Bestimmen eines Restfehlers der räumlichen Ausrichtung nach dem Anpassen der räumlichen Ausrichtung der mindestens einen Projektionsvorrichtung;
- Berechnen eines Projektionsfehlers des auf das zweite Objekt (W) projizierten Bilds basierend auf dem Restfehler bei der räumlichen Ausrichtung der mindestens einen Projektionsvorrichtung (10),
- Anpassen einer Position von mindestens einem von dem ersten (MA) und dem zweiten Objekt (W), um den Projektionsfehler zu minimieren.

## Revendications

1. Système de projection, comprenant au moins un dispositif de projection (10) arrangé pour recevoir un faisceau de projection (PB) provenant d'un premier objet (MA) et pour projeter ce faisceau de projection sur un deuxième objet (W),
le système de projection (PL) comprenant en outre au moins un capteur (11) destiné à mesurer une orientation spatiale de l'au moins un dispositif de projection (10),
dans lequel
le système de projection (PL) comprend au moins une unité de traitement (40) qui est arrangée pour communiquer avec l'au moins un capteur (11 ),
l'au moins une unité de traitement (40) étant arrangée en outre pour communiquer avec un dispositif de positionnement (PW, PM) arrangé pour ajuster la position d'au moins soit le premier objet (MA), soit le deuxième objet (W) sur la base de l'orientation spatiale mesurée de l'au moins un dispositif de projection (10),
et l'unité de traitement (40) étant en outre arrangée pour communiquer avec un dispositif de positionnement supplémentaire (12) arrangé pour ajuster l'orientation spatiale de l'au moins un dispositif de projection (10) sur la base de l'orientation spatiale mesurée de l'au moins un dispositif de projection (10),
**caractérisé en ce que** le système de projection est arrangé pour ajuster la position d'au moins soit le premier objet (MA), soit le deuxième objet (W), sur la base d'une erreur résiduelle après ajustement de l'orientation spatiale de l'au moins un dispositif de projection (10).

2. Système de projection selon n'importe lesquelles des revendications précédentes, **caractérisé en ce que** l'au moins un dispositif de projection (10) comprend au moins soit un miroir, soit des lentilles.

3. Système de projection selon n'importe lesquelles des revendications précédentes, **caractérisé en ce que** l'au moins un dispositif de projection (10) est monté sur le dispositif de positionnement supplémentaire (12) arrangé pour actionner l'au moins un dispositif de projection dans au moins de un à 6 degrés de liberté.

4. Système de projection selon n'importe lesquelles des revendications précédentes, **caractérisé en ce que** le faisceau de projection (PB) est un faisceau de rayonnement ultraviolet extrême.

5. Système de projection selon n'importe lesquelles des revendications précédentes, **caractérisé en ce que** l'au moins une unité de traitement (40) est en outre arrangée pour communiquer avec au moins un capteur supplémentaire (47, 48) afin de déterminer une position d'au moins soit le premier objet (MA), soit le deuxième objet (W).

6. Système de projection selon n'importe lesquelles des revendications précédentes, **caractérisé en ce que** l'au moins une unité de traitement (40) comprend un dispositif E/S (41), un microprocesseur (42) et un dispositif de mémoire (43).

7. Procédé pour l'utilisation d'un système de projection (PL), comprenant au moins un dispositif de projection (10) arrangé pour recevoir un faisceau de projection (PB) provenant d'un premier objet (MA) et pour projeter ce faisceau de projection sur un deuxième objet (W),
le système de projection (PL) comprenant en outre au moins un capteur (11) destiné à mesurer une orientation spatiale de l'au moins un dispositif de projection (10), le procédé comprenant le fait de
- mesurer l'orientation spatiale de l'au moins un dispositif de projection (10) avec l'au moins un capteur (11 ),
- déterminer une erreur d'orientation dans l'orientation spatiale de l'au moins un dispositif de projection (10),
- ajuster l'orientation spatiale de l'au moins un dispositif de projection sur la base de l'erreur d'orientation ;
- déterminer une erreur résiduelle de l'orientation spatiale après ajustement de l'orientation spatiale de l'au moins un dispositif de projection ;
- calculer une erreur de projection de l'image projetée sur le deuxième objet (W) sur la base de l'erreur résiduelle dans l'orientation spatiale de l'au moins un dispositif de projection (10),
- ajuster une position d'au moins soit le premier objet (MA), soit le deuxième objet (W) afin de minimiser ladite erreur de projection.
